# EUROPEAN PATENT APPLICATION

(11) **EP 4 297 206 A1**
(43) Date of publication of application: **27.12.2023**
(21) Application number: 22756309.5
(22) Date of filing: 18.02.2022
(51) Int. Cl.: H01S 5/0683, G02B 6/12, G02B 6/42

(54) **LIGHT EMITTING DEVICE**

(30) Priority: 19.02.2021 JP 2021025667
(71) Applicant: Kyocera Corporation, Kyoto-shi Kyoto 612-8501 (JP)
(72) Inventor: ITAKURA, Yoshiaki, Kyoto-shi, Kyoto 612-8501 (JP)
(74) Representative: Viering, Jentschura & Partner mbB Patent- und Rechtsanwälte
(86) International application number: PCT/JP2022/006767
(87) International publication number: WO 2022/176992

(57) **Abstract**

A light emitter includes a substrate including a first surface, a cladding on the first surface of the substrate, a core inside the cladding, a lid on the cladding, a first light-emitting element inside an element sealing area on the first surface, a second light-emitting element inside the element sealing area, a first light-receiving element inside the element sealing area, and a second light-receiving element inside the element sealing area. A first light-receiving surface of the first light-receiving element faces the lid, and a second light-receiving surface of the second light-receiving element faces the lid.

## Description

### TECHNICAL FIELD

The present disclosure relates to a light emitter.

### BACKGROUND OF INVENTION

A known technique is described in, for example, Patent Literature 1.

### CITATION LIST

### PATENT LITERATURE

Patent Literature 1: WO 2015/012024

### SUMMARY

In an aspect of the present disclosure, a light emitter includes a substrate including a first surface, a first light-emitting element inside an element sealing area on the first surface, a second light-emitting element inside the element sealing area, a cladding on the first surface, a first core inside the cladding to receive light from the first light-emitting element, a second core inside the cladding to receive light from the second light-emitting element, a lid located on the cladding and defining the element sealing area together with the cladding, a first light-receiving element located inside the element sealing area and including a first light-receiving surface facing the lid, and a second light-receiving element located inside the element sealing area and including a second light-receiving surface facing the lid.

In another aspect of the present disclosure, a light emitter includes a substrate including a first surface, a first light-emitting element on the first surface, a second light-emitting element on the first surface, a cladding on the first surface, a first core inside the cladding to receive light from the first light-emitting element, a second core inside the cladding to receive light from the second light-emitting element, a first light-receiving element located on the first surface and including a first light-receiving surface opposite to a surface of the first light-receiving element facing the first surface, a second light-receiving element located on the first surface and including a second light-receiving surface opposite to a surface of the second light-receiving element facing the first surface, and a seal sealing the first light-emitting element, the second light-emitting element, the first light-receiving element, and the second light-receiving element.

### BRIEF DESCRIPTION OF THE DRAWINGS

The objects, features, and advantages of the present disclosure will become more apparent from the following detailed description and the drawings.
FIG. 1 is an exploded perspective view of a light emitter according to an embodiment of the present disclosure.
FIG. 2 is a plan view of the light emitter in FIG. 1 without illustrating a lid.
FIG. 3 is a cross-sectional view of the light emitter taken along section line III-III in FIG. 2.
FIG. 4 is an enlarged cross-sectional view of a light emitter according to another embodiment of the present disclosure.
FIG. 5 is an enlarged cross-sectional view of a light emitter according to another embodiment of the present disclosure.
FIG. 6 is an enlarged cross-sectional view of a light emitter according to another embodiment of the present disclosure.
FIG. 7 is an enlarged cross-sectional view of a light emitter according to another embodiment of the present disclosure.
FIG. 8 is an enlarged cross-sectional view of a light emitter according to another embodiment of the present disclosure.
FIG. 9 is an enlarged cross-sectional view of a light emitter according to another embodiment of the present disclosure.
FIG. 10 is an enlarged cross-sectional view of a light emitter according to another embodiment of the present disclosure.
FIG. 11 is an enlarged cross-sectional view of a light emitter according to another embodiment of the present disclosure.
FIG. 12 is an enlarged cross-sectional view of a light emitter according to another embodiment of the present disclosure.
FIG. 13 is an enlarged cross-sectional view of a light emitter according to another embodiment of the present disclosure.
FIG. 14 is an enlarged cross-sectional view of a light emitter according to another embodiment of the present disclosure.
FIG. 15 is an enlarged cross-sectional view of a light emitter according to another embodiment of the present disclosure.
FIG. 16 is an enlarged plan view of a light emitter according to another embodiment of the present disclosure.

### DESCRIPTION OF EMBODIMENTS

A light emitter with the structure that forms the basis of the present disclosure includes a light source such as a light-emitting element, monitors the intensity of light emitted from the light source, and controls the emitted light to be an intended output. The intensity of light from the light source is monitored using the amount of light received by a light-receiving element in the light emitter.

Patent Literature 1 describes a light source device including optical modules dedicated to the respective colors R, G, and B. Each optical module includes an LD array and a PD array. The PD array receives backward light from the LD array and monitors the light intensity.

For a light-receiving element to receive backward light from a light-emitting element, the light-receiving element is to be mounted with its light-receiving surface facing the light-emitting element, as in the optical modules described in Patent Literature 1. When the light-receiving element has its light-receiving surface, which is the largest surface, facing the light-emitting element, the light-receiving element being mounted can be too tall to reduce the height of the light emitter.

In one or more embodiments of the present disclosure, a light emitter includes a substrate including a first surface, a first light-emitting element inside an element sealing area on the first surface, a second light-emitting element inside the element sealing area, a cladding on the first surface, a first core inside the cladding to receive light from the first light-emitting element, a second core inside the cladding to receive light from the second light-emitting element, a lid located on the cladding and defining the element sealing area together with the cladding, a first light-receiving element located inside the element sealing area and including a first light-receiving surface facing the lid, and a second light-receiving element located inside the element sealing area and including a second light-receiving surface facing the lid.

In one or more embodiments of the present disclosure, a light emitter includes a substrate including a first surface, a first light-emitting element on the first surface, a second light-emitting element on the first surface, a cladding on the first surface, a first core inside the cladding to receive light from the first light-emitting element, a second core inside the cladding to receive light from the second light-emitting element, a first light-receiving element located on the first surface and including a first light-receiving surface opposite to a surface of the first light-receiving element facing the first surface, a second light-receiving element located on the first surface and including a second light-receiving surface opposite to a surface of the second light-receiving element facing the first surface, and a seal sealing the first light-emitting element, the second light-emitting element, the first light-receiving element, and the second light-receiving element.

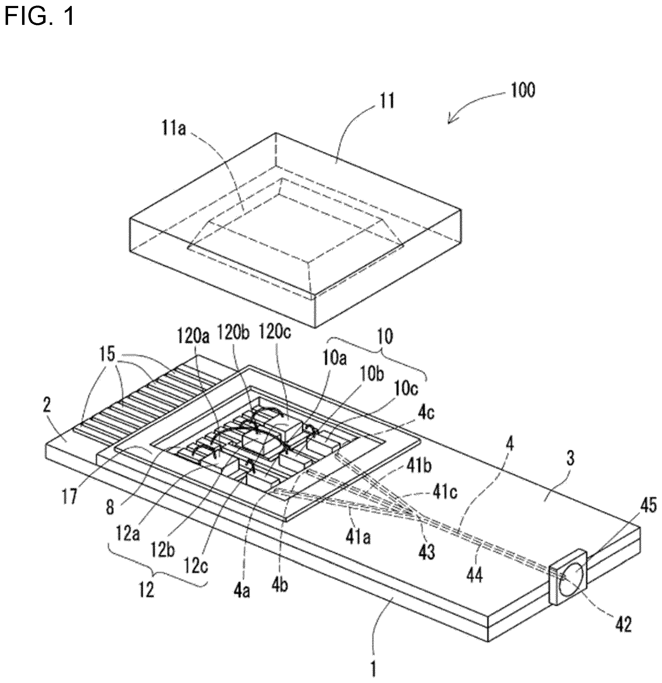

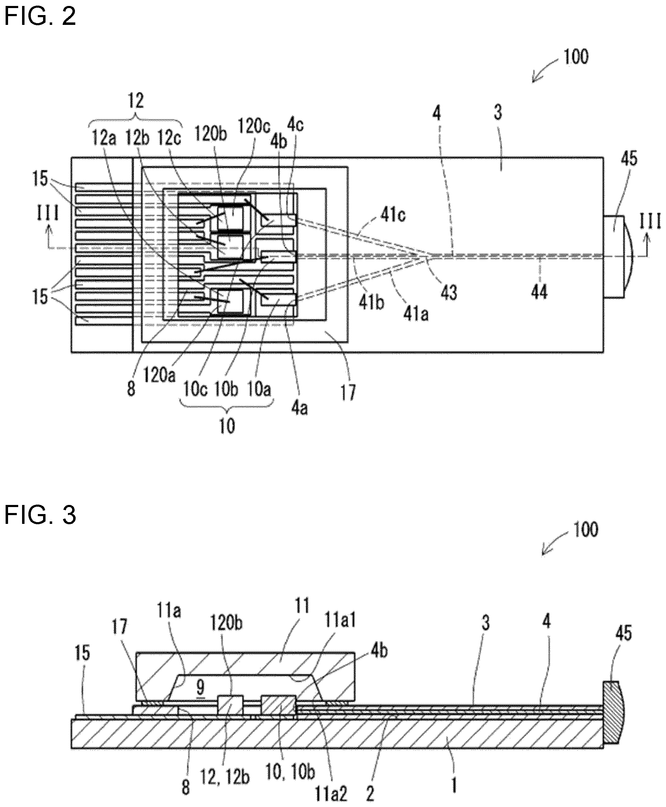

A light emitter according to one or more embodiments of the present disclosure will now be described with reference to the accompanying drawings. In the present embodiment, a light emitter 100 in FIGs. 1 to 3 includes a substrate 1 including a first surface 2, a cladding 3 on the first surface 2 of the substrate 1, a core 4 inside the cladding 3, a lid 11 on the cladding 3, a first light-emitting element 10a inside an element sealing area 9 on the first surface 2, a second light-emitting element 10b inside the element sealing area 9, a first light-receiving element 12a inside the element sealing area 9, and a second light-receiving element 12b inside the element sealing area 9.

In the present embodiment, the light emitter 100 includes a third light-emitting element 10c in addition to the first light-emitting element 10a and the second light-emitting element 10b. The first light-emitting element 10a may be a laser diode that emits, for example, red (R) light. The second light-emitting element 10b may be a laser diode that emits green (G) light. The third light-emitting element 10c may be a laser diode that emits blue (B) light. The first light-emitting element 10a, the second light-emitting element 10b, and the third light-emitting element 10c may be collectively referred to as light-emitting elements 10. In the present embodiment, the light emitter 100 includes a third light-receiving element 12c in addition to the first light-receiving element 12a and the second light-receiving element 12b. The first light-receiving element 12a includes a first light-receiving surface 120a that receives light from the first light-emitting element 10a. The second light-receiving element 12b includes a second light-receiving surface 120b that receives light from the second light-emitting element 10b. The third light-receiving element 12c includes a third light-receiving surface 120c that receives light from the third light-emitting element 10c. The first light-receiving element 12a, the second light-receiving element 12b, and the third light-receiving element 12c may be collectively referred to as light-receiving elements 12. The first light-receiving surface 120a, the second light-receiving surface 120b, and the third light-receiving surface 120c may be collectively referred to as light-receiving surfaces 120. The first light-receiving element 12a may be at any position to receive light from the first light-emitting element 10a, such as behind the first light-emitting element 10a, or in other words, opposite to the core 4. The same applies to the second light-receiving element 12b and the third light-receiving element 12c. A light-receiving element 12 may have an area of 0.4 mm square including a light-receiving surface 120, and a height (thickness) of 0.2 mm.

The substrate 1 may be a ceramic wiring board including dielectric layers made of a ceramic material. Examples of the ceramic material used for the ceramic wiring board include sintered aluminum oxide, sintered mullite, sintered silicon carbide, sintered aluminum nitride, and sintered glass ceramic. For the substrate 1 being a ceramic wiring board, the dielectric layers include conductors such as connection pads, internal wiring conductors, and external connection terminals for electrical connection between the light-emitting and light-receiving elements and an external circuit.

The substrate 1 may be an organic wiring board including dielectric layers made of an organic material. The organic wiring board may be a printed wiring board, a build-up wiring board, or a flexible wiring board. Examples of the organic material used for the organic wiring board include an epoxy resin, a polyimide resin, a polyester resin, an acrylic resin, a phenolic resin, and a fluororesin.

The cladding 3 and the core 4 together serve as an optical waveguide. Both the cladding 3 and the core 4 may be made of glass such as quartz or a resin. In some embodiments, one of the cladding 3 or the core 4 may be made of glass, and the other of the cladding 3 or the core 4 may be made of a resin. The cladding 3 and the core 4 have different refractive indexes. The core 4 has a higher refractive index than the cladding 3. The difference in the refractive index causes total internal reflection of light in the core 4. With the waveguide (core 4) made of a material with a higher refractive index and surrounded by a material with a lower refractive index (cladding 3), light travels through the waveguide with a higher refractive index.

The core 4 includes a first core 41a to receive light from the first light-emitting element 10a, a second core 41b to receive light from the second light-emitting element 10b, a third core 41c to receive light from the third light-emitting element 10c, a merging point 43 that merges the first core 41a, the second core 41b, and the third core 41c, and a joining path 44 that includes an emission end face 42. The first core 41a includes an incident end face 4a. The second core 41b includes an incident end face 4b. The third core 41c includes an incident end face 4c. Light from the first light-emitting element 10a, light from the second light-emitting element 10b, and light from the third light-emitting element 10c travel through the first core 41a, the second core 41b, and the third core 41c and are emitted as combined light through the emission end face 42 of the joining path 44. A lens 45 is located on the optical path of light emitted from the core 4 and may collimate or condense light from the core 4. The lens 45 is, for example, a plano-convex lens with a straight incident surface and a convex emission surface.

The cladding 3 includes a portion surrounding the light-emitting elements 10 and the light-receiving elements 12 mounted on the first surface 2 of the substrate 1. The cladding 3 in the present embodiment may include a through-hole 8. The first light-emitting element 10a, the second light-emitting element 10b, and the third light-emitting element 10c are located in the through-hole 8. The first light-receiving element 12a, the second light-receiving element 12b, and the third light-receiving element 12c are also located in the through-hole 8. The element sealing area 9 in the present embodiment is a space surrounded by the substrate 1, the cladding 3, and the lid 11. The lid 11 in the present embodiment includes a recess 11a. The element sealing area 9 is a space including the through-hole 8. For example, when the cladding 3 is thick enough for the through-hole 8 to accommodate the light-emitting elements 10 and the light-receiving elements 12, the lid 11 may be flat. When the light-emitting elements 10 and the light-receiving elements 12 have heights greater than the thickness of the cladding 3, the lid 11 may include the recess 11a.

The first light-receiving surface 120a of the first light-receiving element 12a faces the lid 11. The second light-receiving surface 120b of the second light-receiving element 12b faces the lid 11. The third light-receiving surface 120c of the third light-receiving element 12c faces the lid 11. The core 4 receives light emitted from the first light-emitting element 10a. The first light-receiving surface 120a of the first light-receiving element 12a receives, inside the element sealing area 9, light that is not received by the core 4 and light emitted through a reflective surface opposite to an emission surface of the light-emitting element. For example, the first light-receiving surface 120a receives light reflected from the inner peripheral surface of the through-hole 8 in the cladding 3 and light reflected from the inner surface of the lid 11. In the present embodiment, the lid 11 includes the recess 11a. In this structure, the first light-receiving surface 120a receives light reflected from the inner surface of the recess 11a. Similarly, the second light-receiving surface 120b of the second light-receiving element 12b receives light emitted from the second light-emitting element 10b inside the element sealing area 9, and the third light-receiving surface 120c of the third light-receiving element 12c receives light emitted from the third light-emitting element 10c inside the element sealing area 9. The light-receiving elements 12 are placed to have their light-receiving surfaces 120 facing the lid 11 to receive light without facing the light-emitting elements 10. The light emitter 100 can be less tall than when the light-receiving elements 12 are placed to have the light-receiving surfaces 120 facing the light-emitting elements 10.

In the present embodiment, the light-emitting elements 10 and the light-receiving elements 12 are connected to external wires 15. The external wires 15 may extend from inside the element sealing area 9 to outside the element sealing area 9. The light-emitting elements 10 and the light-receiving elements 12 include, on their lower surfaces, electrodes directly connected to the external wires 15 and, on their lower surfaces, electrodes connected to the external wires 15 with, for example, bonding wires. The light-emitting elements 10 and the light-receiving elements 12 are electrically connected to an external control circuit through, for example, the external wires 15.

In the present embodiment, the external control circuit may control, for example, the light emission timing for the light emitter 100 to emit light from one of the first light-emitting element 10a, the second light-emitting element 10b, or the third light-emitting element 10c. The first light-receiving element 12a, the second light-receiving element 12b, and the third light-receiving element 12c receive light emitted from the respective light-emitting elements at their light emission timing. The control circuit can adjust outputs of the light-emitting elements 10 based on the amount of received light. For example, the first light-receiving element 12a may receive light at the timing when the first light-emitting element 10a alone is emitting light. Similarly, the second light-receiving element 12b may receive light at the timing when the second light-emitting element 10b alone is emitting light. The third light-receiving element 12c may receive light at the timing when the third light-emitting element 10c alone is emitting light. The control circuit can, for example, adjust a current supplied to each light-emitting element based on the amount of the received light to adjust emitted light to an intended color. The first light-receiving element 12a, the second light-receiving element 12b, and the third light-receiving element 12c may receive light at the timing when the first light-emitting element 10a alone is emitting light. In this case, the control circuit may adjust an output of the first light-emitting element 10a based on the amount of received light. When light is received by, in addition to the first light-receiving element 12a, the second light-receiving element 12b and the third light-receiving element 12c, an increased amount of light can be received by the light-receiving elements 12, allowing more precise adjustment of the light-emitting elements 10.

The light emitter 100 may include a sealing metal film 17 on a portion (facing portion) of the cladding 3 facing the lid 11. The facing portion is between the upper surface of the cladding 3 and the outer periphery of the lower surface of the lid 11, or in other words, between the upper surface of the cladding 3 and the bottom of the lid 11 surrounding the recess 11a. The sealing metal film 17 may be made of a metal material and be a continuous loop surrounding the through-hole 8 in a plan view. The light emitter 100 with the sealing metal film 17 is highly hermetic inside the element sealing area 9.

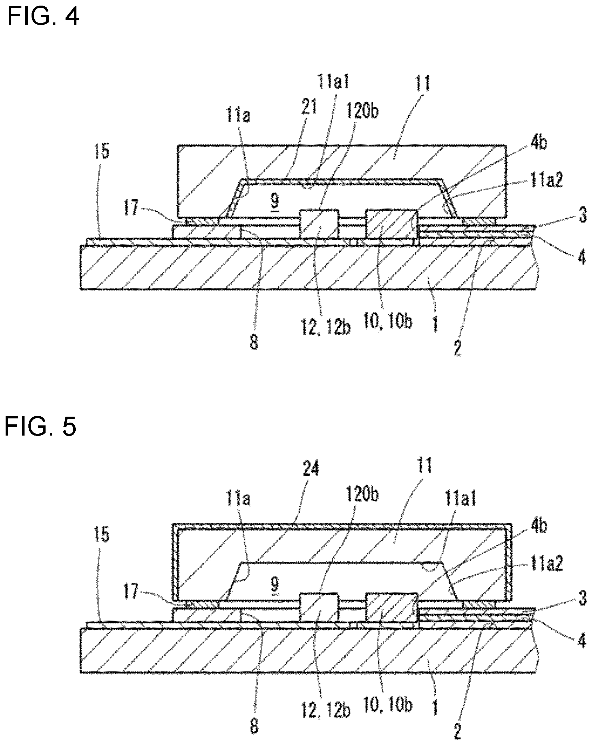

FIG. 4 is an enlarged cross-sectional view of a light emitter according to another embodiment of the present disclosure. FIG. 4 is an enlarged view of a portion near the element sealing area 9. The same reference numerals denote the components corresponding to those in the above embodiment, and such components will not be described repeatedly. In the present embodiment, the lid 11 includes a first reflective film 21 on the inner surface of the recess 11a. The recess 11a includes a bottom 11a1 and sides 11a2 on its inner surface. The first reflective film 21 is located on the bottom 11a1 and the sides 11a2. The first reflective film 21 may be a metal film of, for example, aluminum, chromium, gold, or titanium, or a dielectric multilayer film. Light reaching the inner surface of the recess 11a on the lid 11 is partly reflected, partly transmitted through the lid 11, and partly absorbed by the lid 11. The lid 11 with the first reflective film 21 increases the amount of light reflected inside the element sealing area 9, thus increasing the amount of light received by the light-receiving elements 12. With the light-receiving elements 12 receiving an increased amount of light, the light emitter 100 can control the light-emitting elements 10 more precisely and thus can adjust the color tones more precisely. The lid 11 being a flat plate may include the first reflective film 21 on the surface (lower surface) of the lid 11 facing the substrate 1. The first reflective film 21 is at least located on a portion of the lower surface of the lid 11 facing the element sealing area 9.

FIG. 5 is an enlarged cross-sectional view of a light emitter according to another embodiment of the present disclosure. FIG. 5 is an enlarged view of a portion near the element sealing area 9. The same reference numerals denote the components corresponding to those in the above embodiment, and such components will not be described repeatedly. In the present embodiment, the lid 11 is transparent and includes a fourth reflective film 24 on its outer surface. The transparent lid 11 may transmit light emitted from any of the first light-emitting element 10a, the second light-emitting element 10b, or the third light-emitting element 10c. The fourth reflective film 24 may be a metal film of, for example, aluminum, chromium, gold, or titanium, or a dielectric multilayer film. Light reaching the inner surface of the lid 11 is partly reflected, partly transmitted through the lid 11, and partly absorbed by the lid 11. The lid 11 reflects, with the fourth reflective film 24 included in the lid 11, light transmitted through the lid 11 to inside the element sealing area 9, thus increasing the amount of light received by the light-receiving elements 12.

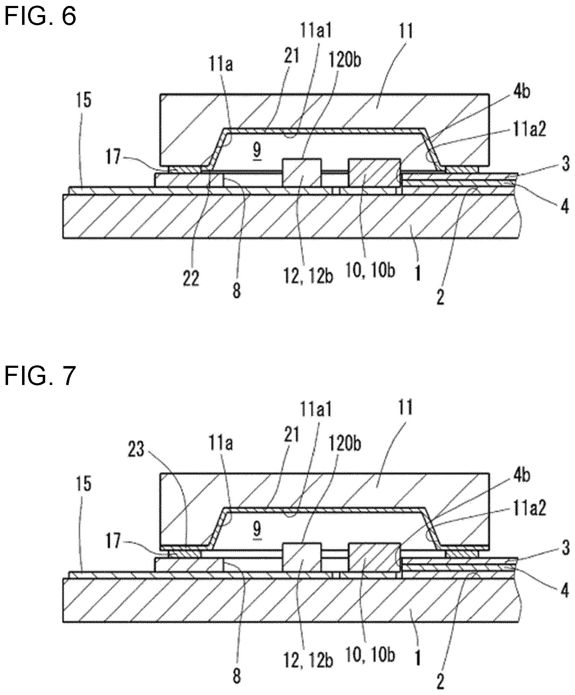

FIG. 6 is an enlarged cross-sectional view of a light emitter according to another embodiment of the present disclosure. FIG. 6 is an enlarged view of a portion near the element sealing area 9. The same reference numerals denote the components corresponding to those in the above embodiment, and such components will not be described repeatedly. In the present embodiment, the lid 11 includes, inward from the sealing metal film 17, a second reflective film 22 continuous with the first reflective film 21. The second reflective film 22 may be, similarly to the first reflective film 21, a metal film of, for example, aluminum, chromium, gold, or titanium, or a dielectric multilayer film. When light travels inside the element sealing area 9, light reaching the first reflective film 21 is reflected from the first reflective film 21, light reaching the sealing metal film 17 is reflected from the sealing metal film 17, and light transmitted through the lid 11 or absorbed by the lid 11 leaks. The second reflective film 22 can reflect light that reaches a portion between the first reflective film 21 and the sealing metal film 17, thus reducing light leakage and increasing the amount of light received by the light-receiving elements 12.

FIG. 7 is an enlarged cross-sectional view of a light emitter according to another embodiment of the present disclosure. FIG. 7 is an enlarged view of a portion near the element sealing area 9. The same reference numerals denote the components corresponding to those in the above embodiment, and such components will not be described repeatedly. In the present embodiment, the lid 11 includes a third reflective film 23 on its portion facing the cladding 3 and continuous with the first reflective film 21. The third reflective film 23 is located on the lower surface of the lid 11 surrounding the recess 11a and overlaps the sealing metal film 17 in a transparent plan view. The third reflective film 23 may be, similarly to the first reflective film 21, a metal film of, for example, aluminum, chromium, gold, or titanium, or a dielectric multilayer film. The third reflective film 23 can reflect, similarly to the second reflective film 22, light that reaches a portion between the first reflective film 21 and the sealing metal film 17, thus reducing light leakage and increasing the amount of light received by the light-receiving elements 12. The lid 11 can be firmly bonded to the cladding 3 by bonding the third reflective film 23 to the sealing metal film 17 on the cladding 3.

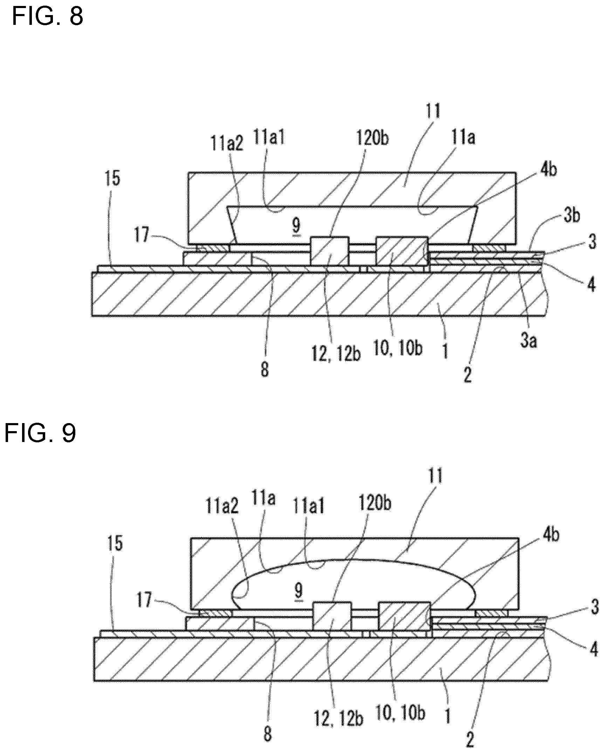

FIG. 8 is an enlarged cross-sectional view of a light emitter according to another embodiment of the present disclosure. FIG. 8 is an enlarged view of a portion near the element sealing area 9. The same reference numerals denote the components corresponding to those in the above embodiment, and such components will not be described repeatedly. In the present embodiment, the recess 11a on the lid 11 includes the bottom 11a1 and the sides 11a2 on its inner surface, with the sides 11a2 sloping outward at greater distances from the cladding 3. The light-receiving surfaces 120 of the light-receiving elements 12 in the present embodiment face the lid 11 and thus easily receive light reflected from the bottom 11a1 when light travels inside the element sealing area 9. The sides 11a2 of the recess 11a slope as described above and thus easily reflect light reaching the sides 11a2 to the bottom 11a1, increasing the amount of light received by the light-receiving elements 12. The lid 11 in FIG. 8 does not include the reflective films 21, 22, and 23, but may include the reflective films 21, 22, and 23.

FIG. 9 is an enlarged cross-sectional view of a light emitter according to another embodiment of the present disclosure. FIG. 9 is an enlarged view of a portion near the element sealing area 9. The same reference numerals denote the components corresponding to those in the above embodiment, and such components will not be described repeatedly. In the present embodiment, the recess 11a includes a dome-shaped inner surface. In this structure, the curved surface reflects light reaching the dome-shaped inner surface inside the element sealing area 9, thus increasing the amount of light received by the light-receiving elements 12. The curved surface may have the shape of a concave lens to focus the reflected light on the light-receiving surfaces 120 to increase the amount of light received by the light-receiving elements 12. In FIG. 9, the sides 11a2 slope outward at greater distances from the cladding 3. The sides 11a2 may extend perpendicularly to the cladding 3, or slope inward from the cladding 3. The lid 11 in FIG. 9 does not include the reflective films 21, 22, and 23, but may include the reflective films 21, 22, and 23.

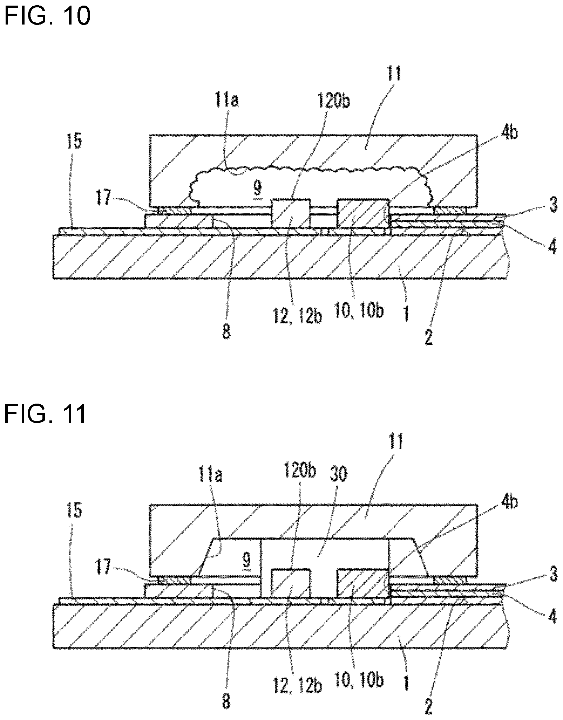

FIG. 10 is an enlarged cross-sectional view of a light emitter according to another embodiment of the present disclosure. FIG. 10 is an enlarged view of a portion near the element sealing area 9. The same reference numerals denote the components corresponding to those in the above embodiment, and such components will not be described repeatedly. In the present embodiment, the recess 11a includes a roughened surface included in its inner surface. The roughened surface may have a roughness greater than the roughness of other surfaces such as outer surfaces. The roughened surface reflects and diffuses light reaching the roughened surface, thus increasing the amount of light received by light-receiving elements 12. The lid 11 in FIG. 10 does not include the reflective films 21, 22, and 23, but may include the reflective films 21, 22, and 23.

FIG. 11 is an enlarged cross-sectional view of a light emitter according to another embodiment of the present disclosure. FIG. 11 is an enlarged view of a portion near the element sealing area 9. The same reference numerals denote the components corresponding to those in the above embodiment, and such components will not be described repeatedly. In the present embodiment, the light emitter 100 includes a partition (hereinafter also referred to as a partition wall 30) that separates the first light-emitting element 10a from the second light-emitting element 10b and separates the first light-receiving element 12a from the second light-receiving element 12b. The partition wall 30 may be a plate extending from the recess 11a of the lid 11 to the substrate 1. The light emitter 100 may include another partition wall 30 to separate the second light-emitting element 10b from the third light-emitting element 10c and separate the second light-receiving element 12b from the third light-receiving element 12c. The partition wall 30 may be made of a light-blocking material that does not transmit light, or a transmissive material with a light-blocking film. The light-blocking partition wall 30 allows light reception without causing the first light-emitting element 10a and the second light-emitting element 10b to emit light at different timings.

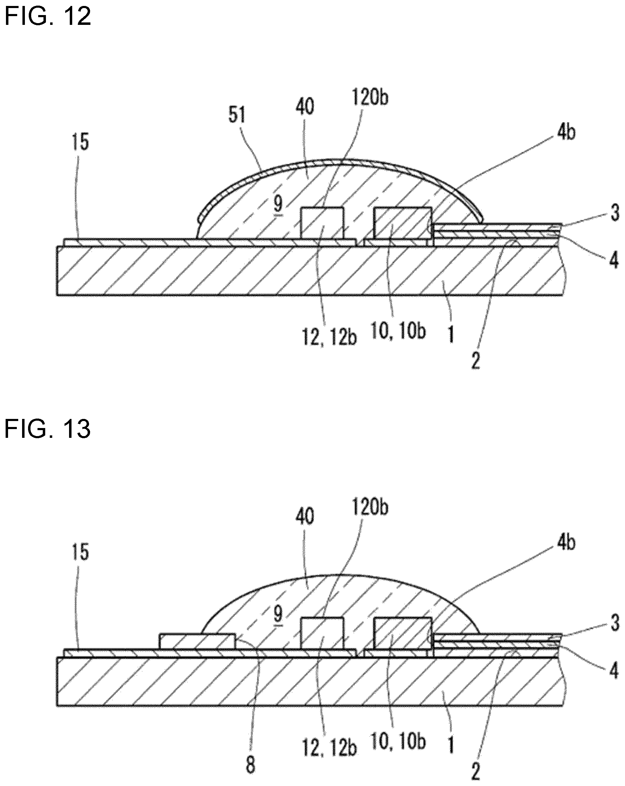

FIG. 12 is an enlarged cross-sectional view of a light emitter according to another embodiment of the present disclosure. FIG. 12 is an enlarged view of a portion near a seal 40. The same reference numerals denote the components corresponding to those in the above embodiment, and such components will not be described repeatedly. The light emitter 100 according to the present embodiment does not include the lid 11, but includes the seal 40 that seals the light-emitting elements 10 and the light-receiving elements 12. The seal 40 is transparent to light emitted from the light-emitting elements 10 to be received by the light-receiving elements 12. The seal 40 may be any material transparent to light emitted from the light-emitting elements 10, such as a resin material or a glass material. The first light-receiving surface 120a of the first light-receiving element 12a is opposite to the surface of the first light-receiving element 12a facing the first surface 2 of the substrate 1. The second light-receiving surface 120b of the second light-receiving element 12b is opposite to the surface of the second light-receiving element 12b facing the first surface 2 of the substrate 1. The third light-receiving surface 120c of the third light-receiving element 12c is opposite to the surface of the third light-receiving element 12c facing the first surface 2 of the substrate 1. This structure is the same as the examples including the lid 11 described above.

In the present embodiment, the light emitter 100 includes the seal 40. In this case, the cladding 3 may not include a portion (through-hole 8) that surrounds the light-emitting elements 10 and the light-receiving elements 12, unlike in the embodiments described above. The light-emitting elements 10 and the light-receiving element 12 may be mounted on the first surface 2 of the substrate 1, connected to the external wires 15, and sealed by the seal 40.

The light-receiving surfaces 120 of the light-receiving elements 12 in the present embodiment receive light from the light-emitting elements 10 reflected at the boundary between the seal 40 and the external space. With the light-receiving surfaces 120 of the light-receiving elements 12 being opposite to the surface facing the first surface 2 of the substrate 1 to receive light without facing the light-emitting elements 10, the light emitter 100 can be less tall.

When the seal 40 in the present embodiment is made of a transparent resin, moisture from the surrounding environment or outside air may permeate the transparent resin. The seal 40 thus includes a fifth reflective film 51 on its outer surface as illustrated in FIG. 12. The fifth reflective film 51 may be a metal film of, for example, aluminum, chromium, gold, or titanium, or a dielectric multilayer film. The fifth reflective film 51 can reduce the likelihood of moisture or outside air permeating the seal 40. The fifth reflective film 51 also reflects light, which is then received by the light-receiving surfaces 120. The fifth reflective film 51 thus increases the amount of light reflected inside the seal 40, increasing the amount of light received by the light-receiving elements 12. With the light-receiving elements 12 receiving an increased amount of light, the light emitter 100 can control the light-emitting elements 10 more precisely and thus can adjust the color tones more precisely.

FIG. 13 is an enlarged cross-sectional view of a light emitter according to another embodiment of the present disclosure. FIG. 13 is an enlarged view of a portion near the seal 40. The same reference numerals denote the components corresponding to those in the above embodiment, and such components will not be described repeatedly. In the present embodiment, the cladding 3 includes the through-hole 8 and surrounds the seal 40 in the direction along the first surface 2 of the substrate 1. The seal 40 in a softened or fluid state covers the light-emitting elements 10 and the light-receiving elements 12 and then is cured. When the cladding 3 includes a portion surrounding the seal 40, such as the through-hole 8 as in the present embodiment, the cladding 3 can prevent the seal 40 in a softened or fluid state from flowing out of the cladding 3 during sealing and facilitate the formation of the seal 40.

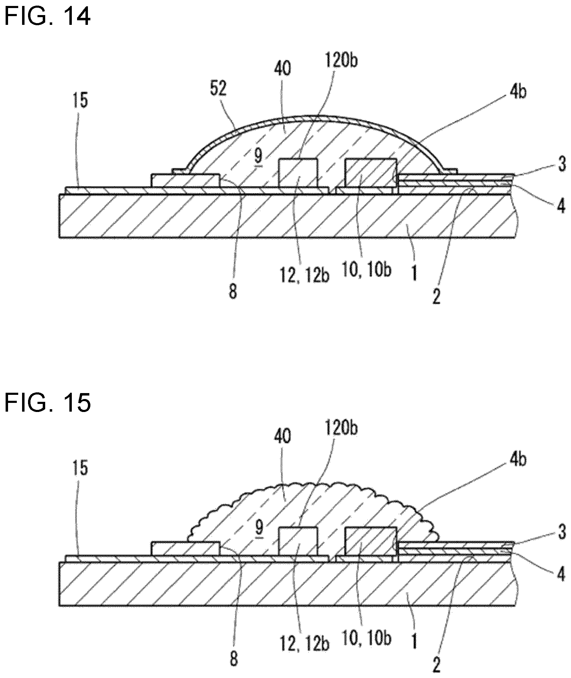

FIG. 14 is an enlarged cross-sectional view of a light emitter according to another embodiment of the present disclosure. FIG. 14 is an enlarged view of a portion near the seal 40. The same reference numerals denote the components corresponding to those in the above embodiment, and such components will not be described repeatedly. In the present embodiment, the cladding 3 includes the through-hole 8, and a sixth reflective film 52 is located on the outer surface of the seal 40. The sixth reflective film 52 may be a metal film of, for example, aluminum, chromium, gold, or titanium, or a dielectric multilayer film. The sixth reflective film 52 extends from the outer surface of the seal 40 to the cladding 3. The seal 40 is thus surrounded by the cladding 3 and the sixth reflective film 52, reducing light leakage and increasing the amount of light received by the light-receiving elements 12.

FIG. 15 is an enlarged cross-sectional view of a light emitter according to another embodiment of the present disclosure. FIG. 15 is an enlarged view of a portion near the seal 40. The same reference numerals denote the components corresponding to those in the above embodiment, and such components will not be described repeatedly. In the present embodiment, the seal 40 includes a roughened surface included in its outer surface. The roughened surface may have a roughness greater than the roughness of other surfaces. The roughened surface reflects and diffuses light reaching the roughened surface, thus increasing the amount of light received by the light-receiving elements 12. The seal 40 in FIG. 15 does not include the sixth reflective film 52, but may include the sixth reflective film 52.

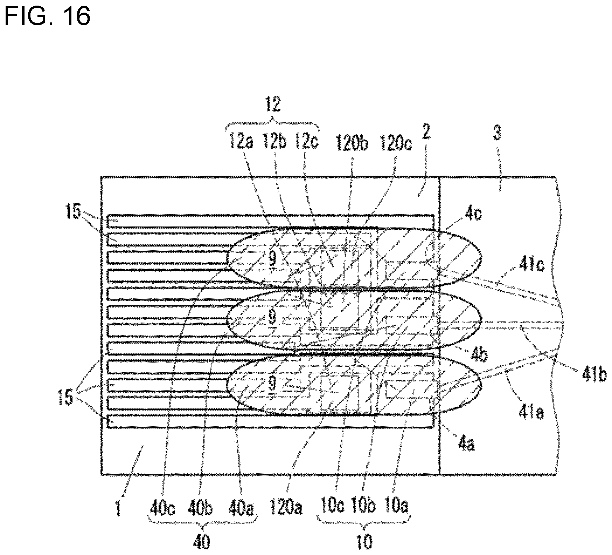

FIG. 16 is an enlarged cross-sectional view of a light emitter according to another embodiment of the present disclosure. FIG. 16 is an enlarged view of a portion near a first seal 40a, a second seal 40b, and a third seal 40c. The same reference numerals denote the components corresponding to those in the above embodiment, and such components will not be described repeatedly. In the present embodiment, the seal 40 includes the first seal 40a, the second seal 40b, and the third seal 40c. The first seal 40a seals the first light-emitting element 10a and the first light-receiving element 12a. The second seal 40b seals the second light-emitting element 10b and the second light-receiving element 12b. The third seal 40c seals the third light-emitting element 10c and the third light-receiving element 12c. The first seal 40a, the second seal 40b, and the third seal 40c are separate from one another. For example, light emitted from the first light-emitting element 10a inside the first seal 40a is reflected at the boundary between the first seal 40a and the external space and received on the first light-receiving surface 120a of the first light-receiving element 12a. When part of the emitted light permeates the first seal 40a into the external space, the light is less likely to enter the adjacent second seal 40b. When the first seal 40a has light-blocking properties, the light is still less likely to enter the adjacent second seal 40b. The same applies to the second seal 40b and the third seal 40c.

Although the embodiments of the present disclosure have been described in detail, the present disclosure is not limited to the embodiments described above, and may be changed or varied in various manners without departing from the spirit and scope of the present disclosure. The components described in the above embodiments may be entirely or partially combined as appropriate unless any contradiction arises.

### REFERENCE SIGNS

1 substrate
2 first surface
3 cladding
4 core
4a, 4b, 4c incident end face
8 through-hole
9 element sealing area
10 light-emitting element
10a first light-emitting element
10b second light-emitting element
10c third light-emitting element
11 lid
11a recess
11a1 bottom
11a2 side
12 light-receiving element
12a light-receiving surface
15 external wire
17 sealing metal film
21 first reflective film
22 second reflective film
23 third reflective film
24 fourth reflective film
30 partition wall (partition)
40 seal
40a first seal
40b second seal
40c third seal
41a first core
41b second core
41c third core
42 emission end face
43 merging point
44 joining path
45 lens
51 fifth reflective film
52 sixth reflective film
100 light emitter

## Claims

1. A light emitter, comprising:
a substrate including a first surface;
a first light-emitting element inside an element sealing area on the first surface;
a second light-emitting element inside the element sealing area;
a cladding on the first surface;
a first core inside the cladding, the first core being configured to receive light from the first light-emitting element;
a second core inside the cladding, the second core being configured to receive light from the second light-emitting element;
a lid on the cladding, the lid defining the element sealing area together with the cladding;
a first light-receiving element inside the element sealing area, the first light-receiving element including a first light-receiving surface facing the lid; and
a second light-receiving element inside the element sealing area, the second light-receiving element including a second light-receiving surface facing the lid.

2. The light emitter according to claim 1, wherein
the lid includes a recess, and
the recess includes an inner surface including a bottom and a side.

3. The light emitter according to claim 2, wherein
the inner surface of the recess includes a first reflective film.

4. The light emitter according to claim 3, wherein
the first reflective film is on the bottom and the side.

5. The light emitter according to claim 3 or claim 4, further comprising:
a sealing metal film on a facing portion of the cladding facing the lid,
wherein the lid includes, inward from the sealing metal film on the facing portion, a second reflective film continuous with the first reflective film.

6. The light emitter according to claim 3 or claim 4, further comprising:
a sealing metal film on a facing portion of the cladding facing the lid,
wherein the lid overlaps the sealing metal film on the facing portion in a transparent plan view and includes a third reflective film continuous with the first reflective film.

7. The light emitter according to claim 2, wherein
the lid is transparent, and
the lid includes a fourth reflective film on an outer surface of the lid.

8. The light emitter according to any one of claims 4 to 7, wherein
the recess includes the side sloping outward at a greater distance from the cladding.

9. The light emitter according to any one of claims 4 to 7, wherein
the inner surface of the recess is dome-shaped.

10. The light emitter according to claim 2 or claim 3, wherein
the inner surface of the recess includes a roughened surface.

11. The light emitter according to any one of claims 1 to 10, wherein
the lid includes a partition separating the first light-emitting element from the second light-emitting element and separating the first light-receiving element from the second light-receiving element, and the partition blocks light.

12. A light emitter, comprising:
a substrate including a first surface;
a first light-emitting element on the first surface;
a second light-emitting element on the first surface;
a cladding on the first surface;
a first core inside the cladding, the first core being configured to receive light from the first light-emitting element;
a second core inside the cladding, the second core being configured to receive light from the second light-emitting element;
a first light-receiving element on the first surface, the first light-receiving element including a first light-receiving surface opposite to a surface of the first light-receiving element facing the first surface;
a second light-receiving element on the first surface, the second light-receiving element including a second light-receiving surface opposite to a surface of the second light-receiving element facing the first surface; and
a seal sealing the first light-emitting element, the second light-emitting element, the first light-receiving element, and the second light-receiving element.

13. The light emitter according to claim 12, wherein
the seal is surrounded by the cladding in a direction along the first surface.

14. The light emitter according to claim 12, wherein
the seal is transparent, and
the seal includes a fifth reflective film on an outer surface of the seal.

15. The light emitter according to claim 13, wherein
the seal is transparent, and
the seal includes a sixth reflective film on an outer surface of the seal.

16. The light emitter according to claim 12 or claim 13, wherein
the seal includes a roughened surface included in an outer surface of the seal.

17. The light emitter according to any one of claims 12 to 16, wherein
the seal includes a first seal sealing the first light-emitting element and the first light-receiving element, and a second seal sealing the second light-emitting element and the second light-receiving element.

18. The light emitter according to any one of claims 1 to 17, further comprising:
a lens in an optical path of light emitted from the first core and the second core.
